# EUROPEAN PATENT SPECIFICATION

(11) **EP 0 469 587 B1**
(45) Date of publication and mention of the grant of the patent: **27.11.1996**
(21) Application number: 91112892.4
(22) Date of filing: 31.07.1991
(51) Int. Cl.: G05F 3/20, G11C 5/14

(54) **Improvements in or relating to integrate circuits**
Verbesserungen in oder in Beziehung zu integrierten Schaltungen
Améliorations dans ou relatives à des circuits intégrés

(30) Priority: 31.07.1990 US 560662
(43) Date of publication of application: 05.02.1992
(73) Proprietor: TEXAS INSTRUMENTS INCORPORATED, Dallas Texas 75265 (US)
(72) Inventor: Redwine, Donald J., Houston, Texas 77031 (US); Iyengar, Narasimhan, Plano, Texas 75093 (US); Cline, Dan R., Plano, Texas 75023 (US); Loh, Wah Kit, Richardson, Texas 75080 (US); McAdams, Hugh P., Houston, Texas 77084 (US)
(74) Representative: Leiser, Gottfried, Dipl.-Ing.

(56) References cited:
- DE-A- 3 924 952
- GB-A- 2 111 336
- PATENT ABSTRACTS OF JAPAN vol. 14, no. 48 29 January 1990 & JP-A-12 76 486
- PATENT ABSTRACTS OF JAPAN vol. 10, no. 8 14 January 1986 & JP-A-60 170 962
- PATENT ABSTRACTS OF JAPAN vol. 12, no. 173 24 May 1988 & JP-A-62 284 391
- PATENT ABSTRACTS OF JAPAN vol. 9, no. 207 24 August 1985 & JP-A- 60 069 896
- PATENT ABSTRACTS OF JAPAN vol. 9, no. 147 (E-323)(1870) 21 June 1985 & JP-A-60 28 258

## Description

This invention relates to integrated circuits, and in particular to integrated circuit devices formed in a semiconductor substrate, for example memory devices such as dynamic random access memories having substrate bias generators as indicated in the preamble of claim 1 and as eg known from GB-A-2 111 336.

The development of very large scale integrated circuit (VLSI) semiconductor devices of the Dynamic Random Access Memory (DRAM) type is well known. Over the years, the industry has steadily progressed from DRAMS of the 16K type (as shown in the U.S. Pat. 4,055,444 issued to Rao) to DRAMS of the 1MB type (as shown in U.S. Pat. 4,658,377 issued to McElroy), and progressed to DRAMS of the 4MB type. A 16MB DRAM, wherein more than 16 million memory cells and associated circuitry are integrated on a single memory chip, is the next generation of DRAM scheduled for production.

Presently in designing VLSI semiconductor memory devices of the 16MB DRAM type, designers are faced with numerous challenges.

One cause for concern, for example, is speed. It is known that the performance of an integrated circuit device may be improved by applying a bias voltage to the semiconductor substrate in which the circuit is formed. For an example of application of such bias in the field of DRAMs, reference may be made to United States Patent 4,825,142.

Another cause for concern is device power consumption and accordingly it is an object of the present invention to provide an improved circuit for applying a substrate bias without excessive power consumption, particularly when the device is in a standby mode, that in a regime of no or reduced device activity.

JP-A-12 76 486 discloses also a substrate bias generator composed of two bias generators. The first bias generator (10) is operated during the stand-by mode and stopped during the active mode, and the second bias generator (20) is stopped during the stand-by mode and operated during the active mode until the substrate bias arrives at a prescribed value.

According to the present invention in a first aspect thereof an integrated circuit device is realised as indicated in claim 1. It is formed in a semiconductor substrate, and has a circuit for providing a bias to said substrate, said circuit comprising:
a first bias generator to provide a substrate bias in a standby mode of said device,
a second bias generator to provide a substrate bias in an active mode of said device, and
a third bias generator to provide a substrate bias in the active mode of said device and only when the substrate voltage level falls below a preset level. Advantageously the circuit is adapted to adjust to provide a bias to said substrate less than a level which adversely increases Vt of the device transistors, yet sufficient to avoid junction leakage currents. Where the said substrate is a p-type substrate, said circuit may provide a bias level of about -2 volts.

In a preferred arrangement of an integrated circuit device in accordance with the present invention said first bias generator is adapted to activate upon power up of said device and remains active until the power of the device is removed. Advantageously, at least one of said bias generators includes an oscillator and pump and preferably the first bias generator may include an oscillator and pump adapted to run continuously whilst power is applied to said device. Preferably a bias generator includes means to drive an oscillator to produce a square wave advantageously comprising a plurality of stages each for successively steepening the wave gradient of said square wave. The oscillator may comprise a plurality of inverters to provide said square wave signals.

An alternative preferred arrangement of an integrated circuit device in accordance with the present invention includes dynamic memory wherein the oscillator and pump of the second bias generator provide a substrate bias when a RAS control input of said memory changes to active low.

In a yet further preferred arrangement of an integrated circuit device in accordance with the present invention the oscillator of said first bias generator is of relatively lower power and the oscillator of the second bias generator is of relatively higher power.

According to the present invention in a further aspect thereof there is provided a method for controlling voltage level of a substrate upon which an integrated circuit device is formed as indicated in claim 13. It comprises the steps of:
providing a low power oscillator and pump to provide a substrate bias in a standby mode of said device,
providing a high power oscillator and pump to provide a substrate bias in an active mode of said device,
and providing a booster oscillator and pump to provide a substrate bias when said device is in said active mode and only when the substrate voltage level is greater than a preset level. The method may further comprise the step of adjusting said circuit to bias said substrate to a bias level less than a level which adversely increases Vt of the transistors of the device, and to a sufficiently high level to avoid junction leakage currents.

As part of this application an exemplary circuit for providing a bias to the substrate of a dynamic memory device having a memory array and peripheral circuitry formed in a semiconductor substrate is disclosed. The circuit includes a low power pump and oscillator to provide a substrate bias in a memory standby mode. A high power pump and oscillator is included to provide a substrate bias when the memory is active. A booster oscillator and pump to provide a substrate bias when the memory is active and when the substrate voltage level is greater than a preset level is also provided. A method for controlling the voltage level of the substrate upon which a dynamic memory device is formed is also disclosed.

The objects, advantages and features of the invention will become apparent to those of ordinary skill in the art, having reference to the following description of embodiments of the invention which together with the accompanying drawings are provided by way only of example.

In the drawings:-
FIG. 1 is a block system level drawing illustrating a 16MB Dynamic Random Access Memory chip incorporating an embodiment of the invention,
FIG. 2 is a top view drawing illustrating the pin designations of the packaged memory chip,
FIG. 3 is a three-dimensional view of the packaged memory chip wherein the encapsulating material is rendered transparent,
FIG. 4 is an assembly view if FIG. 3,
FIG. 5 is a cross-sectional view of FIG. 3,
FIG. 6 is a top view drawing illustrating the bond pad designations of the memory chip,
FIG. 7 is a top view drawing illustrating a portion of the memory array,
FIG. 8 is a cross-sectional view of a portion of the memory array,
FIG. 9 is a side view of the cross-sectional view of FIG. 8,
FIG. 10 is a general flow diagram of the substrate bias voltage VBB.
FIG. 11 is a general arrangement drawing of the supply/drive and bias elements of Circuit TLCCALL.
FIG. 12 illustrates the Low Power Oscillator Circuit, LPOSC.
FIG. 13 illustrates the VBB Low Power Pump Circuit, VBBLPP.
FIG. 14 illustrates the High Power Pump Circuit, HPOSC.
FIG. 15 illustrates the VBB High Power Pump Circuit VBBHPP.
FIG. 16 illustrates the Power Up Boost Oscillator Circuit, BOSC.
FIG. 17 illustrates the VBB Booster Pump circuit, VBBPB.
FIG. 18 illustrates the VBB Detector Circuit, VBBDET, and
FIG. 19 illustrates the RCL Circuit.

APPENDIX I illustrates substrate characterization data. The substrate pump characterization data shows timing and power in formation for the substrate pump circuits.

An exemplary embodiment of the invention and a memory chip including the invention will now be described.

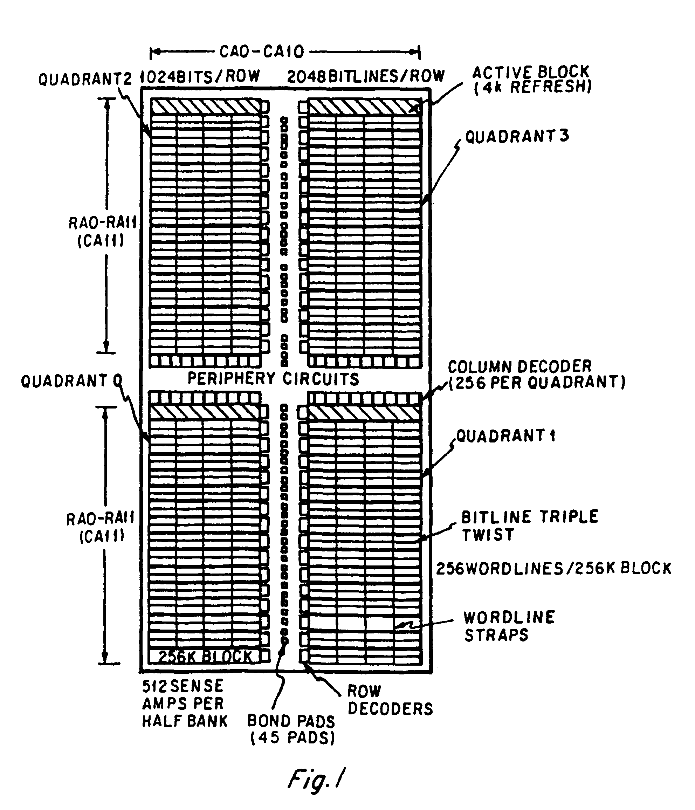

Fig. 1 illustrates a 16 Megabit Dynamic Random Access Memory Chip referred to as a 16MB DRAM. The chip size is about 325 X 660 mm. The chip is partitioned into four memory array quadrants. Each memory array quadrant contains 4 Megabits. A 4MB memory array quadrant contains 16 memory blocks. Each memory block contains 256 Kilobits. The Column Decoders lie along the vertical axis of the chip adjacent to their respective memory array quadrants. The ROW decoders lie along the horizontal axis of the chip, adjacent to their respective memory array quadrants. The periphery circuits containing such devices as the input and output buffers and the timing and control circuits are centrally located along both the horizontal and the vertical axis of the chip. The bond pads are centrally located along the horizontal axis of the chip.

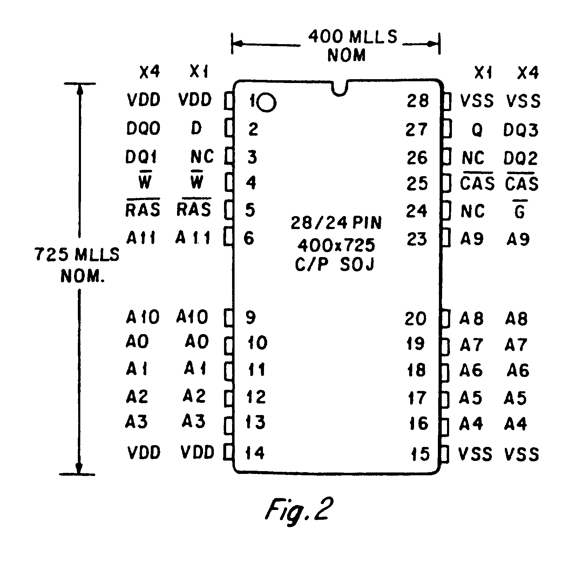

FIG. 2 is a top view drawing illustrating the package/pin out of the device. The chip is center bonded and encapsulated in a thin plastic, small outline J-type package. Among other features, the DRAM is bond programmable as either an X1 or an X4 device. The pin designations for both the X1 and X4 modes of operation are illustrated.

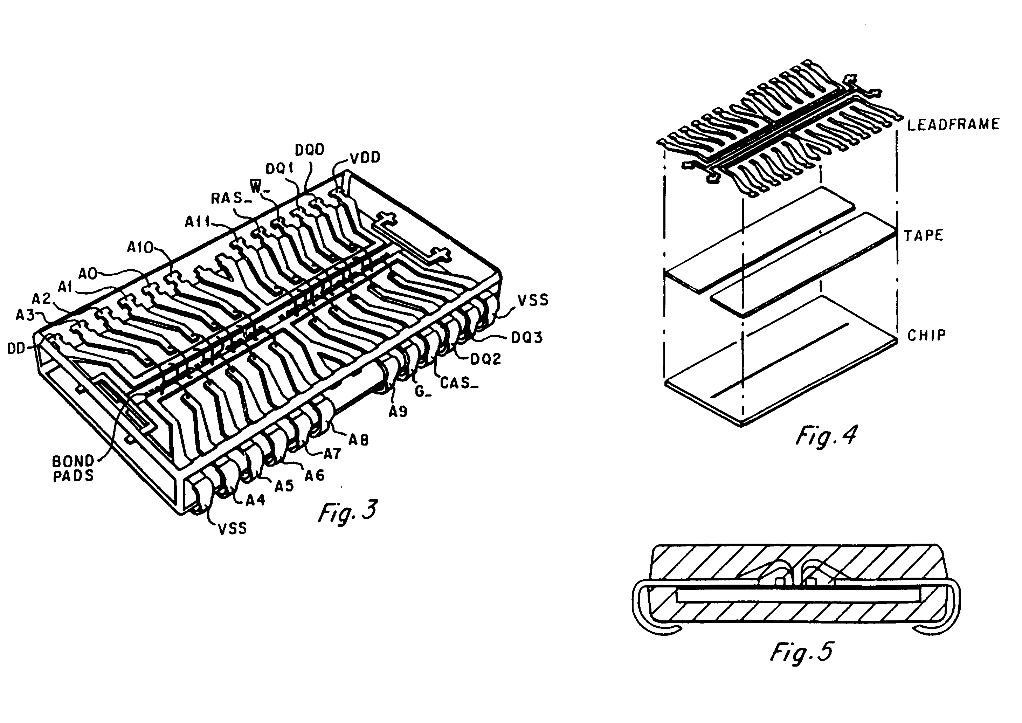

FIG. 3 is a three-dimensional view of the encapsulated chip wherein the encapsulating plastic is rendered transparent. The pin designations shown correspond to the X4 option. The TSOJ package is of the lead over chip with center bond (LOCCB) type. Basically, the chip lies underneath the lead fingers. A polyamide tape attaches the chip to the lead fingers. Gold wires are wire-bonded from the lead fingers to the center bonding pads of the chip.

FIG. 4 is an assembly view of the packaging concept and

FIG. 5 is a cross-section view of the packaged device.

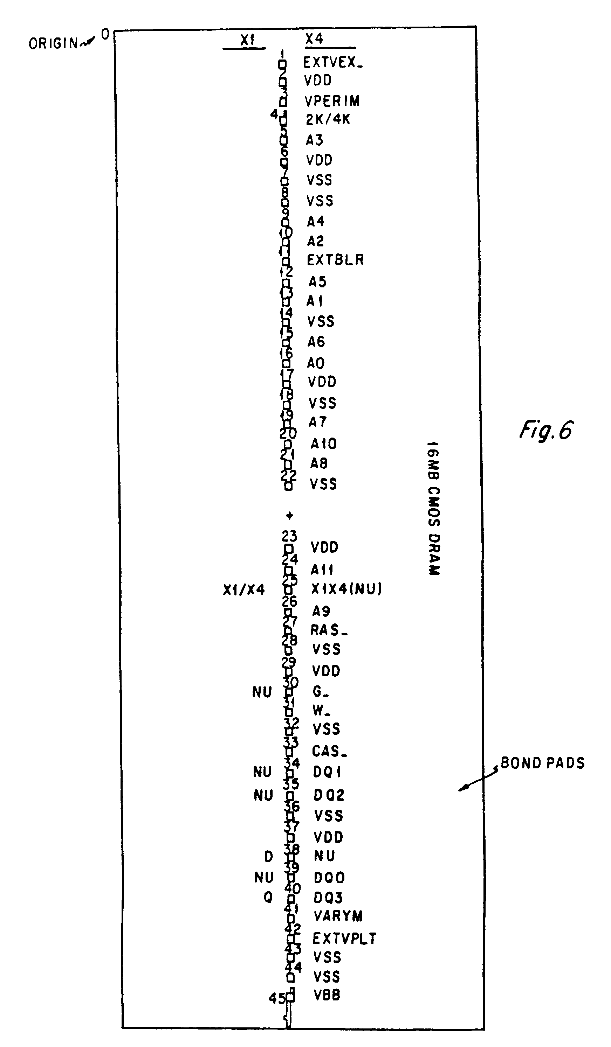

FIG. 6 is a diagram illustrating the names and sequence of the bond pads. The sequence for both the X1 and the X4 options are illustrated. EXT BLR is a pad that is for in-house only. The brackets, such as those for bond pad 4 and 25 indicate that this is a bond pad option.

General characteristics of the 16MB DRAM device of FIG. 1 follow. The device receives external VDD of typically 5 volts. On chip internal voltage regulation powers the memory arrays at 3.3 volts and the periphery circuits at 4.0 volts to reduce power consumption and channel hot carrier effects. The substrate is biased at -2 volts. The organization is bond programmable X1/X4. The X1 or X4 option may be selected during manufacture by putting in place a bond wire between bond pad 25 (FIG. 6) and V_{SS} for a X1 device and omitting the bond wire for a X4 device. The resulting pin outs for the ten options may be seen in FIG. 2. The bond wire may be run between pad 25 and the V_{SS} bus 3 of the lead frame (FIG. 3).

The enhanced page mode is the preferred option, with a metal mask programmable option for a write per bit (data mask) operation.

The preferred option for the refresh scheme is 4096 cycles at 64ms. However, the DRAM is bond programmable for 2048 cycle refresh. Option selection may be achieved in a way analogous to that employed for the X1 or X4 option selection. The relevant bond pad is 4, bonded to V_{SS} for 2K refresh, otherwise the 4K refresh option is exercised.

The DRAM has numerous design-for-test features. Test mode entry 1 is through WCBR with no address key for 16X internal parallel test with mode data compare. Test mode entry 2 is WCBR with over-voltage and address key only thereafter (8 volts on A11). Exit from test mode occurs from any refresh cycle (CBR or RAS only). Test mode entry 1 is the industry standard 16X parallel test. This test is similar to those used on the 1MB and 4MB DRAMS, except that 16 bits are compared simultaneously instead of 8 bits. The valid address keys are A0, A1, A2, and A6. Test mode entry 2 contains numerous tests. There is a 32X parallel test with data compare and a 16X parallel test with data compare. Different hexadecimal addresses are keyed for the different parallel tests. A storage cell stress test and a VDD margin test allows connection of the external VDD to internal VARY and VPERI device supply lines through the P-channel devices. Other tests include a redundancy signature test, a row redundancy roll call test, a column redundancy roll call test, a row transfer test, a word-line leakage detection test, clear concurrent test modes, and a reset to normal mode. The DRAM also contains a test validation method that indicates if it has remained in a test mode.

Although not illustrated in FIG. 1, for clarity, the DRAM contains redundancy features for defect elimination. It has four redundant rows per 256K memory block. All four may be used at one time. There are 3 decoders per redundant row and 11 row addresses per redundant row decoder. It uses fuses for row redundancy with, on-average, 10 fuses blown for a single repair. The row redundancy uses a two stage programmable concept to more efficiently to enable repair. There are 12 redundant columns per quadrant and four decoders per redundant column. There are 8 column addresses and 3 row addresses per decoder. The total fuse count for column repair is about, on average, 10 fuses blown for a single repair. Column redundancy also has a two-stage programmable feature to more efficiently enable repair.

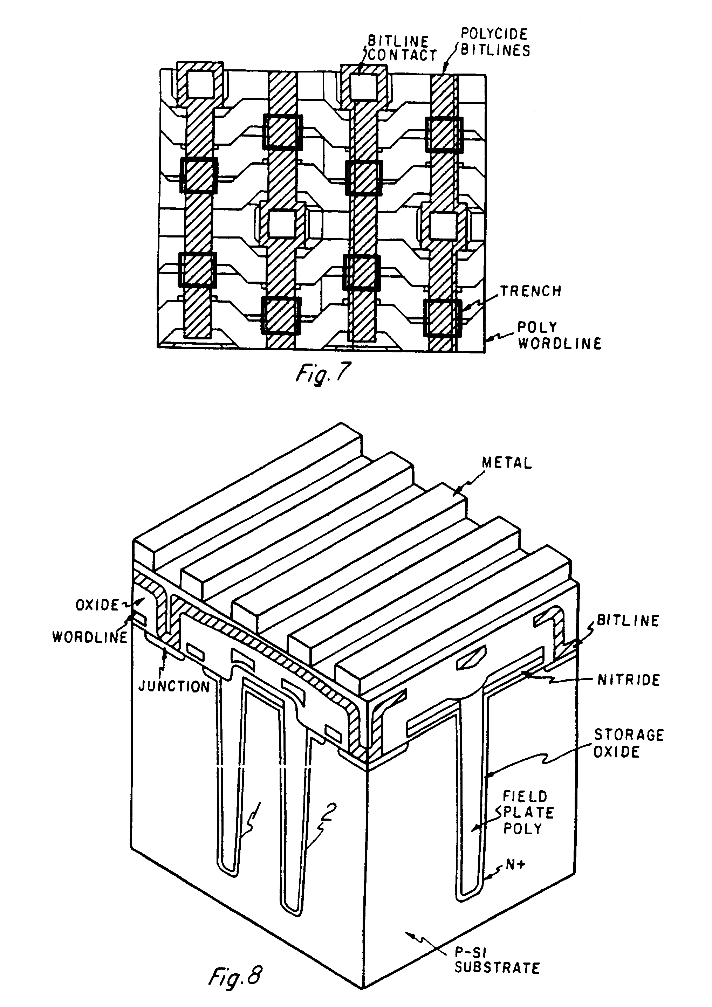

FIG. 7 is a top view of the capacitor cell layout. The bit lines are poly-3 (TiSi₂) polyside. No bitline reference is used and the bitlines are triple twisted for noise immunity. The supply line voltage is about 3.3 volts. The word lines are segmented poly-2. They are strapped every 64 bits with metal 2. The memory cells are of the modified trench capacitor type and may be formed by a process such as disclosed in United States Patent 5,017,506 and European Patent Application 0410288.

Alternative suitable memory cells of the stacked trench-type are disclosed in United States Patent 4,978,634.

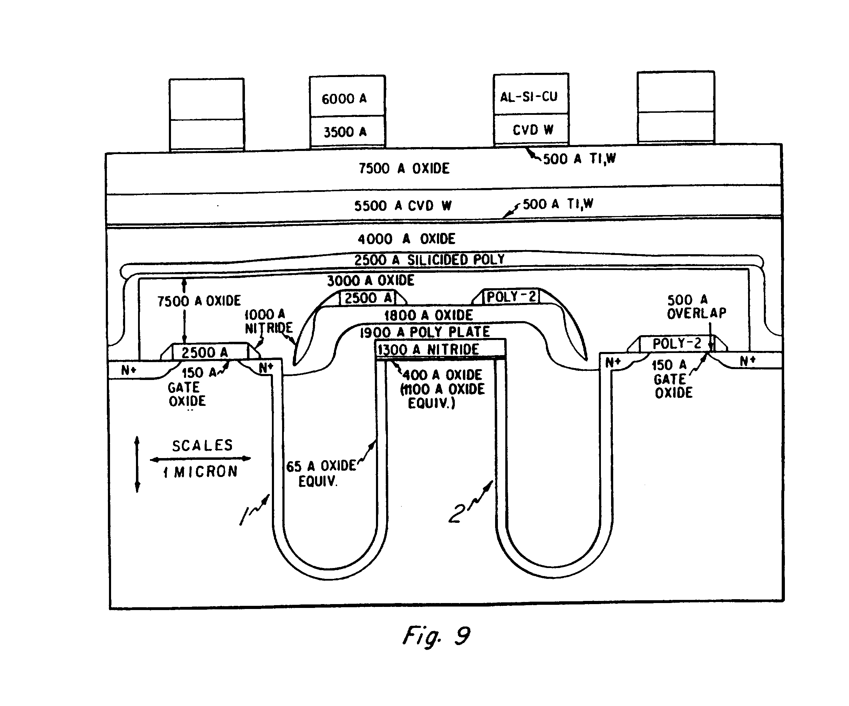

In FIG. 7, the dimensions include a 1.6um bit-line pitch by 3.0um double word line pitch, with a cell size of about 4.8um² obtained through 0.6 micron technology. The trench opening is about 1.1um and the trench depth is about 6.0um. The dielectric is of nitride/oxide, having a thickness of about 65A. Field plate isolation is utilized. The transistors have thin gate oxide. FIG. 8 is a cross-sectional view of the modified trench capacitor cell and FIG. 9 is a side view of the trench capacitor cell.

This embodiment of the invention, a 16M DRAM (16Meg) is built on p-type substrate. For performance enhancement, the substrate needs in addition be biased to a negative level. By doing so, it prevents forward biasing of junctions, thus avoiding the flow of minority carriers, and it reduces the junction capacitance of the p-substrate transistors. But it cannot be biased to be too negative as it also increases the threshold voltage (Vt) of the transistors. The optimum selected bias level is -2Volts.

In biasing the substrate, 16Meg uses three sets of oscillators and pumps. They are;
a. Low power oscillator and pump, LPOSC & VBBLPP.
b. High power oscillator and pump, HPOSC & VBBHPP.
c. Booster oscillator and pump, BOSC & VBBPB.
These oscillators and pumps are activated differently. First LPOSC and VBBLPP. This low power set serves as substrate bias supply in standby mode. Hence, it is activated upon power up and remains active throughout until the power of the device is switched off.

Next, HPOSC and VBBHPP. These may also be known as the activity oscillator and activity pump. As the name suggests, they are activated only when there is an activity, ie when RAS_ goes to active low, such as during a page mode. This is to support the first pump, VBBLPP to maintain the VBB level during the active cycle.

Lastly, BOSC and VBBPB. This provides a fast charging of VBB to the required level upon power up. In addition, it also acts as an emergency pump as it is activated whenever the VBB level is more positive than -1 volt. Under normal operating conditions BOSC and VBBPB are off.

During device power up VBB is being pumped down to its -2.0 volt level; during this time, as VPERI (the power supply for the circuits which access the DRAM cell array) is established, RID goes high and resets all the R/S latches in the control logic. This establishes a known starting point for the control logic. Also, as VBB is pumped down it is monitored by the VBBDET circuit and upon reaching its required level, a signal generated by the VBBDET circuit, VBS_ resets RID. This releases the control latches and completes the basic power up sequence, enabling the device to start any of its normal memory cycles.

In the VBB circuits, there is a probe pad, EXTODS. By forcing this pad to a logic '1', it disables all three oscillators. Thus, indirectly, it disables the VBB pumps. In doing so, it also means that the substrate voltage will never go down to the required level. Hence, the device will always be in the preset state. In order to avoid this, an active logic '1' EXTODS also forces the device out of its preset state with a time constant delay or approximately 2--5 usec.

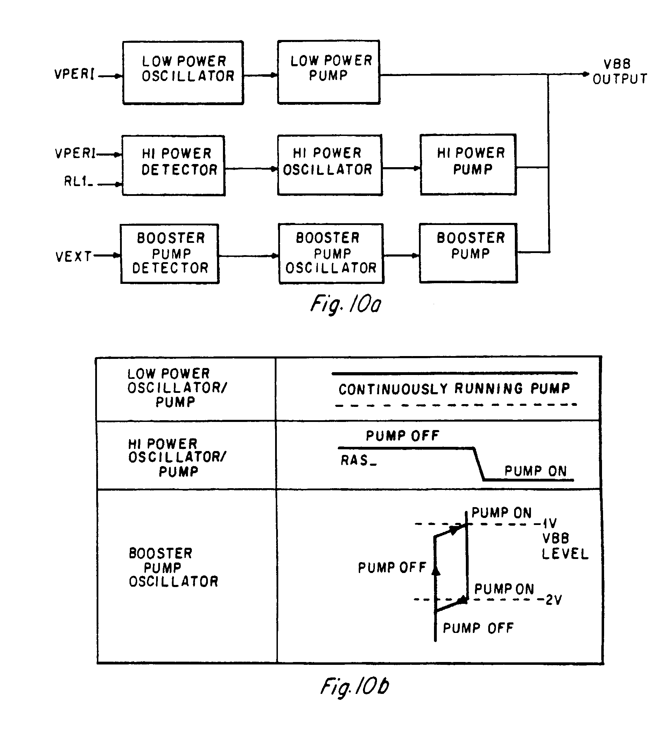

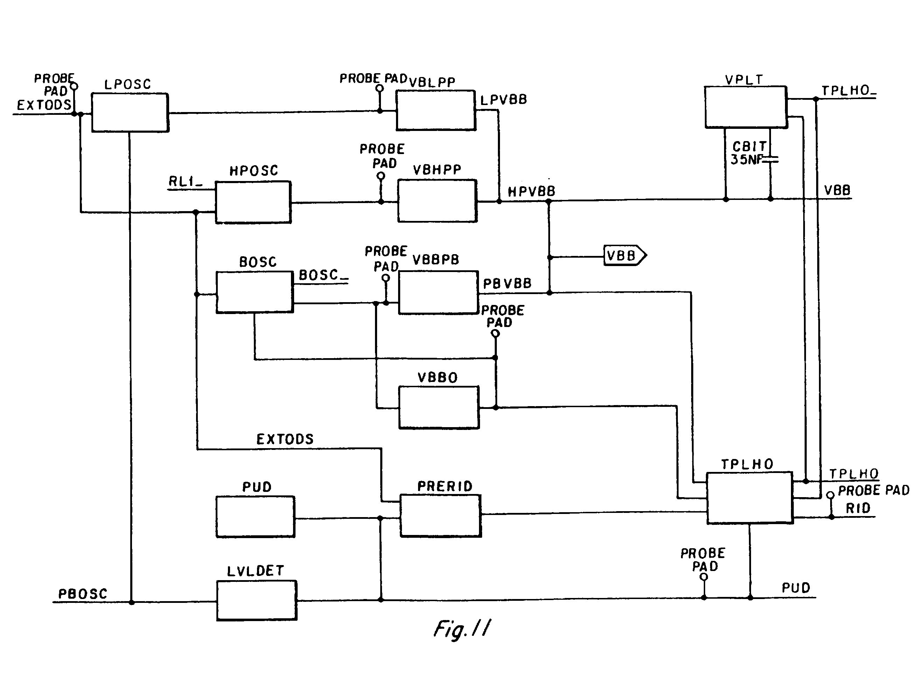

FIG. 10 is a general flow and timing diagram of VBB generation.

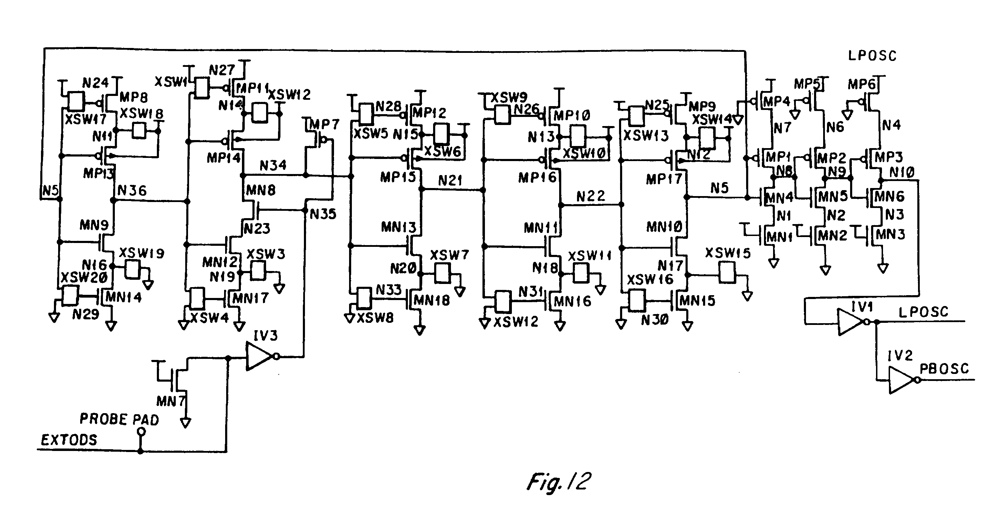

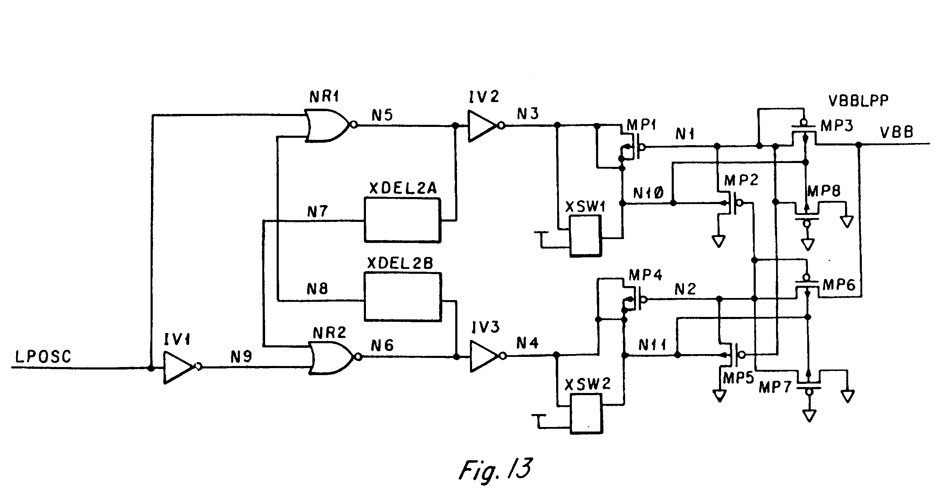

FIG. 11 is a block diagram of the VBB generator system.

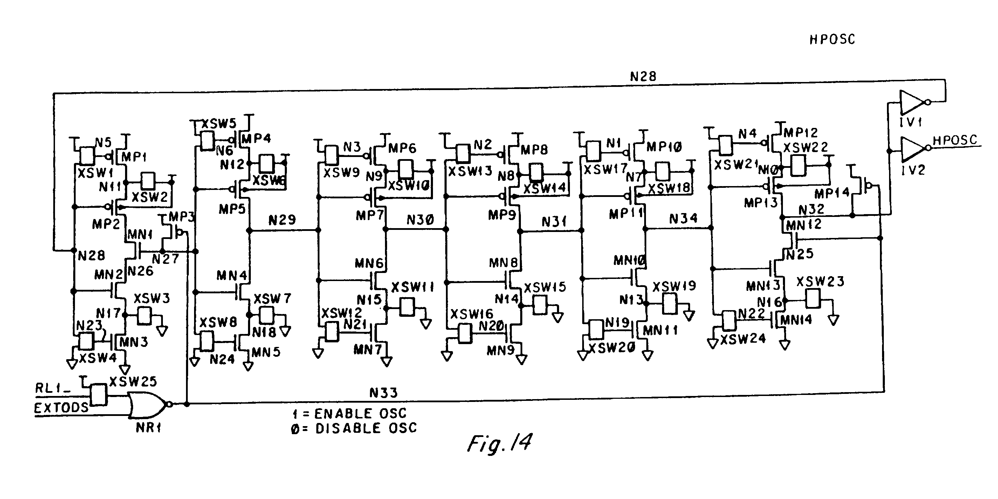

APPENDIX I contains substrate characterization data.
- LPOSC: - LOW POWER OSCILLATOR
- schematic FIG. 12

This oscillator generates a square wave signal which drives the low power or the standby VBB pump. A loop of five inverters is used to provide a signal of about 1 usec cycle time, 1MHz. These inverters are designed with programmable sizing of the p-channel and n-channel transistors. This enables adjustment of oscillator frequency when needed, achieving the required cycle time by controlling the W/L ratio of the inverters. The resulting waveform has a slow rise and fall time. To convert this signal into a square waveform, a set of 3 modified inverters is connected to the output of the loop, ie node N5. These inverters amplify the signal, increasing the rise and fall times until a square wave is generated.

The oscillating signal can be inhibited by injecting a high level signal at probe pad EXTODS. This breaks the loop of inverters and forces node N5 to a low potential. Thus, the output LPOSC is forced low and becomes a static output.

There are two outputs, LPOSC and PBOSC. LPOSC is used for the VBB pump and PBOSC is used as booting signal for various parts of the device.

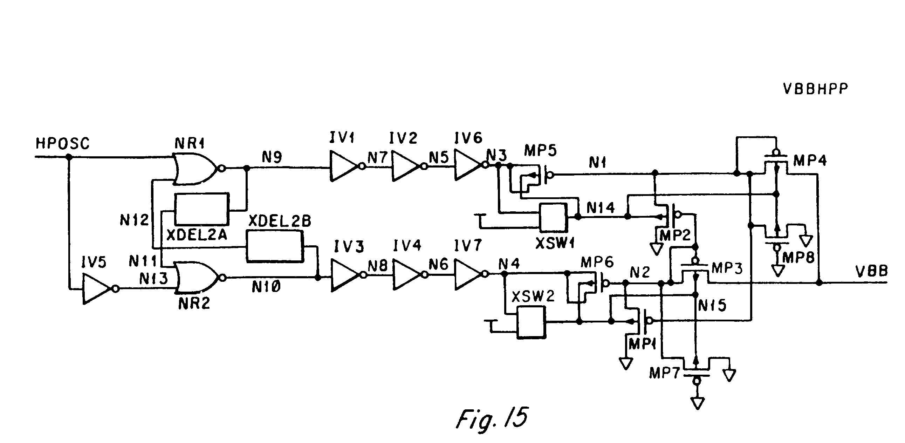

Finally, note that the transistors MN11 and MN16 are sized differently from the other inverters. This is to avoid a situation where the output is locked at an intermediate level at power up. This is accomplished by changing the D.C. transfer curve of one invertor in the loop of five inverters.
- VBBLPP: - VBB LOW POWER PUMP
- schematic FIG. 13

This is the VBB standby pump. It has two P-channel capacitors, MP and PM4, two P-channel transistors, MP3 and MP6 connected in the form of diodes and two pull down P-channel transistors, MP2 and MP5. The operation is achieved by generating two clocks of different phase (180 degrees) at nodes N3 and N4.

The above two clocks, are generated from the low power oscillator output, LPOSC by gating it with the delayed signals from XDEL2A and XDEL2B.

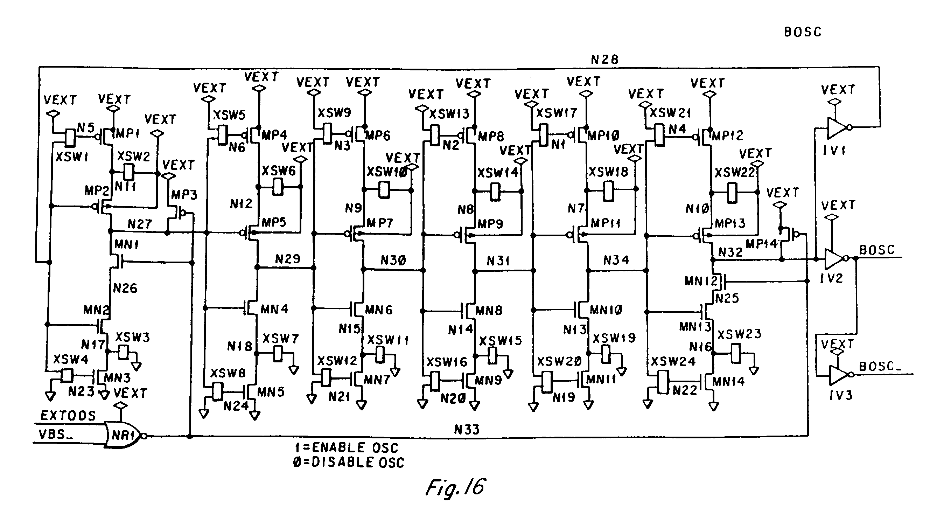

In the first phase of pumping, starting with N3 high and N4 low, and assuming zero potential, the P-channel capacitor MP1 is charged slightly through P8, a startup transistor. N1 arises momentarily and then settles back to the Vtp of the MP8 transistor. This places a charge of Omp1 = Cmpi1(VPERI - 2 /Vtp/) into the P-channel capacitor MP1. As N3 falls and N4 rises, N1 is driven negative bringing the gate and drain of MP3 down with it. This turns on the pump diode MP3, since Vbb is assumed to be zero at this time, and pumps positive charge out of the substrate. This forces the P-channel capacitor MP4 in the same manner as N3 charged MP1; except that MP4 is charged through MP7 instead of MP8. As the voltage of the nodes of the pump are established N1 and N2 begin to swing between VSS and a negative level of about -(VPERI - /Vtp/). When N1 goes negative it turns on MP5, which clamps N2 to Vss. This allows more charge to build up on MP4 such that Omp4 = (VPERI - /Vtp/). A similar action occurs when N2 goes negative and turns on MP2, allowing a charge of Omp1 = (VPERI - /Vtp/) to build up in Mp1. Eventually, the capacitors are charged through MP2 and MP5 instead of MP7 and MP8. It should be noted that the substrate voltage VBB will reach an approximate level of -(VPERI - 2 /Vtp/) or - (VPERI - /Vtmp1/ - /Vtmp3/). Thus for VPERI - 4v and Vtp = -1.0v, VBB would be - 2.0 volts. As VBB reaches this value the pump diodes MP3 and MP6 will shut off and the pumping charge will cease to flow.
- HPOSC: - HIGH POWER OSCILLATOR
- BOSC: - BOOSTER OSCILLATOR
- schematic FIG. 14 and 16.

These two oscillators are designed the same. The difference is HPOSC uses VPERI as supply whereas BOSC uses external voltage VDD (VEXT) as supply. These oscillators provide square waveforms of 3MHz.

Both circuits are designed with seven inverters connected in feedback loop to produce a ring oscillator. One stage having a different transfer ratio so the oscillator can start up automatically when power is applied. Each stage having programmable transistor sizes to allow some adjustment in the frequency of oscillation.

HPOSC is gated by RL1_ (derived from RAS), hence, it is only activated during RAS_ low time, cycling once on short memory cycles, and multiple times on a page mode cycle where RAS_ is held low for extended periods of time. HPOSC is arranged to run faster than the corresponding oscillator of the first bias generator so that a larger power demand can be accommodated. BOSC is gated on and off by VBS_ which is controlled by VBBDET, the VBB detector circuit. Thus, when VBB is insufficient, VBS_ will be low and BOSC will be activated. BOSC drives the booster pump VBBPB which generates the substrate bias during power up.

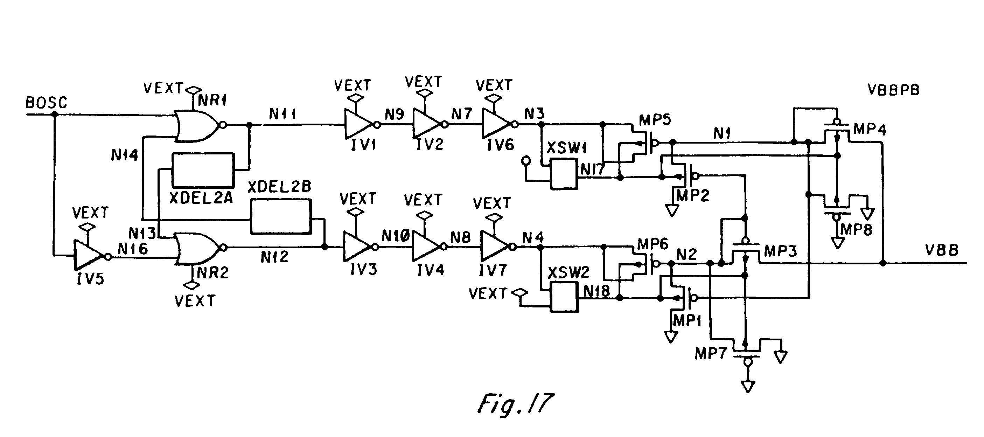

As in the case of LPOSC, an externally applied signal EXTODS, can be used to disable the oscillators, HPOSC and BOSC, and indirectly their pumps if substrate bias is to be applied externally.
- VBBHPP: - VBB HIGH POWER PUMP
- VBBPB: - VBB BOOSTER PUMP
- schematic FIG. 15 and 17

VBBHPP is the pump that is activated only when there is an active cycle, ie RL1_ is low. The booster pump VBBPB, is activated when the VBB level is insufficient. Both pumps are controlled by the activating of their oscillators HPOSC and BOSC. The pump of the second oscillator (VBBHPP) is fabricated with output transistors larger than that of the first to provide a higher power capability.

These two pumps work exactly the same way as LPOSC, where they need two out of phase clocks at node N3 and N4. These clocks control the two phase pumping action.

Note that even though both pumps are the same, they are supplied by different voltage levels. VBBHPP is supplied by VPERI which is regulated to 4.0V, whereas, VBBPB is supplies directly from external VDD, NEXT, which is 5.0V nominal. Thus the driving capability of the two pumps are different.

MAX possible VBB level to be driven by VBBHPP is:
= Vss - (VPERI - 2Vt)
= OV - (4V - 2Vt) ; taking Vt of MPS, MP4, Mp5 & MP6 to be 1.0V
= - 2V ; VPERI regulated to 4V.
MAX possible VBB level to be driven by VBBPB is:
= Vss - (VEXT - 2Vt)
= OV - (5V - 2(1.0)) ; taking Vt of MP3, MP4, MP5 & MP6 to be 1.0V
= - 3V ; nominal external voltage to be 5V

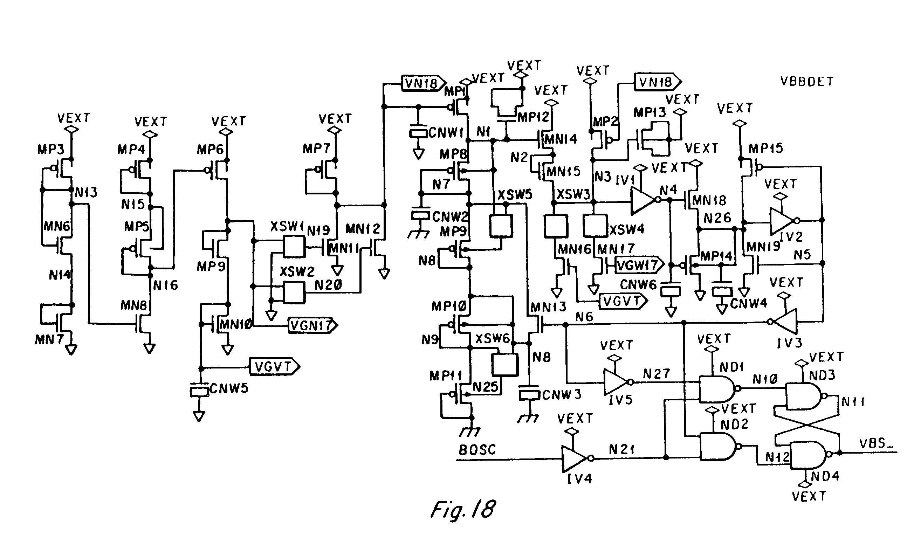

Thus, under normal conditions, with an external supply of 5V, VBBPB has a higher driving capability compared to VBBHPP.
- VBBDET: - VBB DETECTOR
- schematic FIG. 18.0

VBBDET is used to detect the VBB level and then signals the booster oscillator when to switch on and off. This circuit has a series of transistors, MP3 through MP7 and MN6 through MN12, to regulate the gate potential of MP1. This potential generates an almost constant current through MP1 and by doing so node N1 is always 4 Vts above the substrate voltage. The 4 Vts are associated with transistors MP8 through MP11. The voltage regulation on the gate of MP1 is effective over a wide range of supply voltage and temperature changes.

On power up, node N1 and N3 track the external voltage. This is achieved through transistors MP1, Mp2 and P-channel capacitors MP12 and MP13. As the supply voltage goes up, the voltage regulator transistors, MP3 through MP7 and MN6 through MN12, begin to turn on, supplying a gate voltage to MN16. This allows MN14 and MN15 to become an active source follower, with N3 being 2 Vts down from N1. As MN16 turns on, N3 begins to drop until it comes back under the control of N1. High Vbb still at zero, N1 will be at 5.0 volts and N3 will be near 3.0 volts. This is enough voltage to force node N4, the output of the high ration invertor IV1, to zero. A logic "O" on node N4 is equivalent to signaling BOSC to continue oscillating during power up. The output of IV1, N4 goes into a complementary source follower, MP14 and MN18, that drives a regenerative detector composed of IV2 and MP15 and MN19. The complementary source follower is to buffer the low drive capability of IV1 into the latch detector. The output of the falling edge of BOSC, ie when N21 rises, into a edge trigger latch, ND3 and ND4 so that VBS_ sets in a decisive manner to turn BOSC on and off.

Returning to N1 and N3, as VBB is pumped down it will eventually reach -2.0 volts. At this point N1 will be 4 Vts. higher or about +4.0 volts higher that VBB. Thus, N1 will be around +2.0 volts and N3 will be about 0.0 volts. A logic "O" on N3 will cause a logic "1" on node N4, which translates into a high sate on VBS_, signaling BOSC to turn off. In response to N4 going high, the regenerative latch detector trips, driving N26 high and node N5 low. Node N5 flips N6 to a logic "1" which turns on MN13, this shorts out one P-channel transistor in the detector stack, pulling N1 down about 1.0 volt further. This causes VBB to have to rise an extra volt, from -2.0 v to -1.0 v in order to turn BOSC back on. Thus switching MN13 in and out produces the hysteresis in the VBB detection.

As will be apparent from the foregoing, the present invention finds application in integrated circuit devices having a standby mode. An example of such a device might be a circuit having a power supply which is operative at a relatively high power capability when the device is active and a relatively low power capability when inactive or in stand by. A stand by mode, for example, would be one in which device leakage currents only are being supplied. In the use of a DRAM, a stand by mode might be when the Row Address Strobe (RAS) is in its inactive (high) state meaning that no external access to the memory array itself is expected.

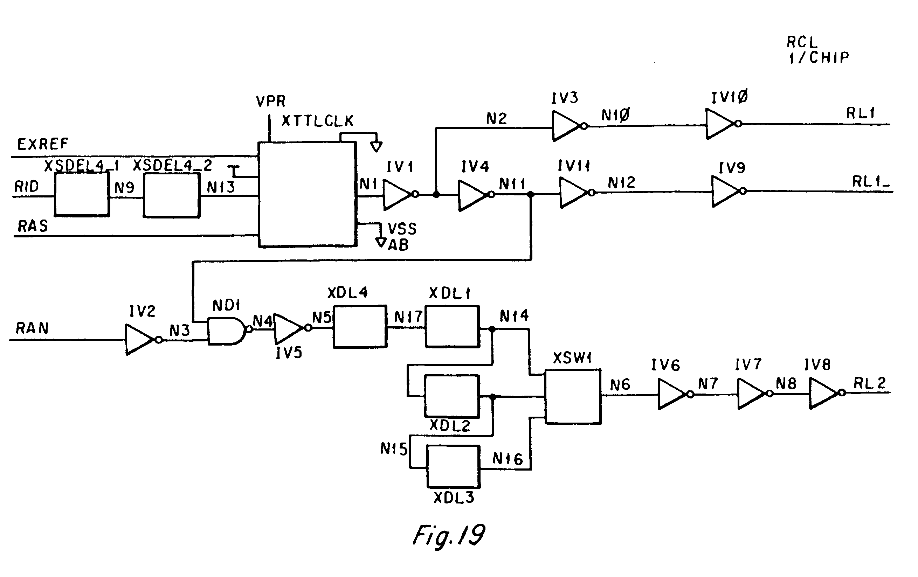

In the present embodiment, for example, the second oscillator HPOSC is controlled by a signal RL1_ (fig. 14), acting through NOR gate NR1. As may be seen from FIG. 19, RL1_ is derived from RAS via clocking circuit XTTLCLK and invertors IV4, and IV9.

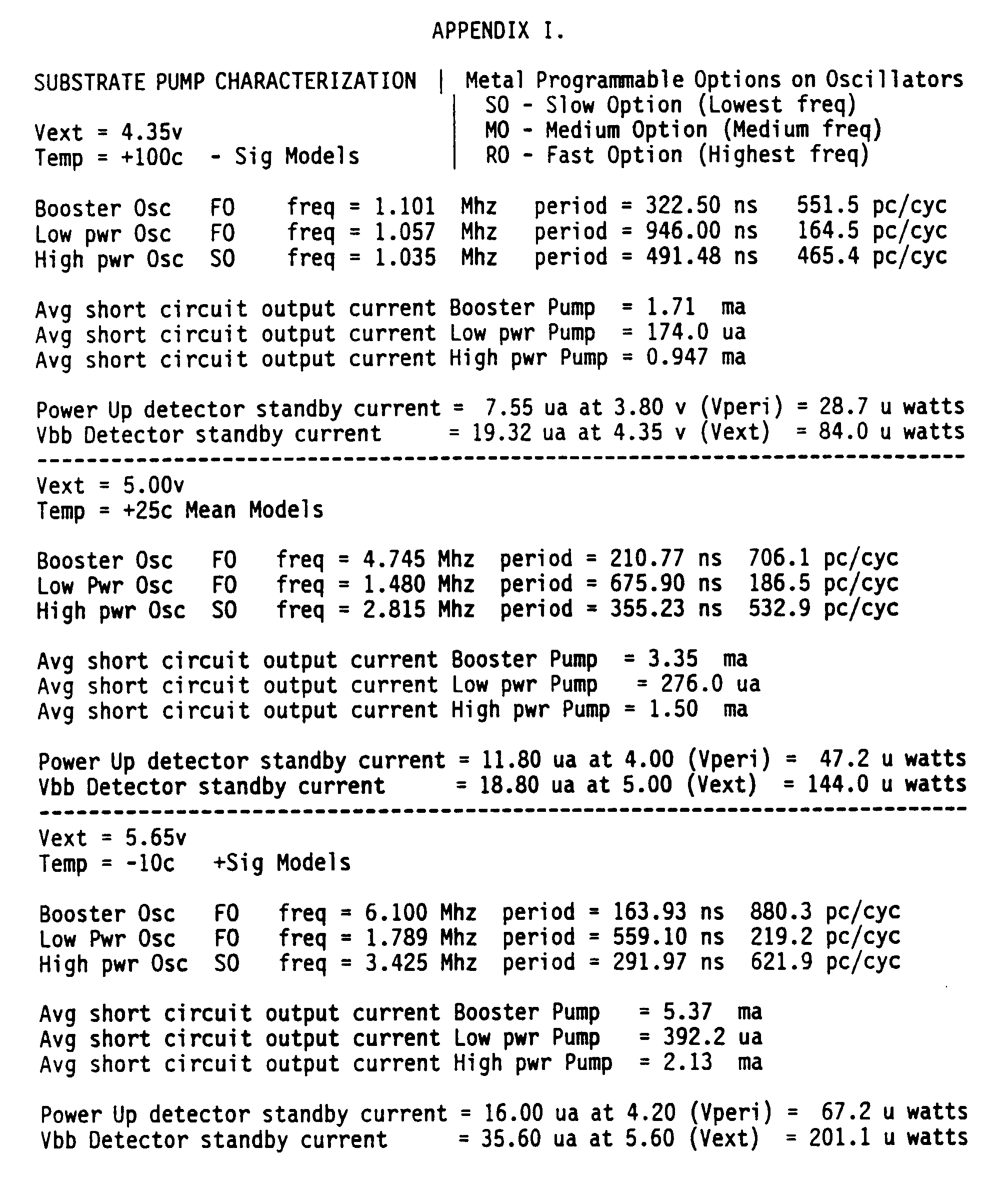

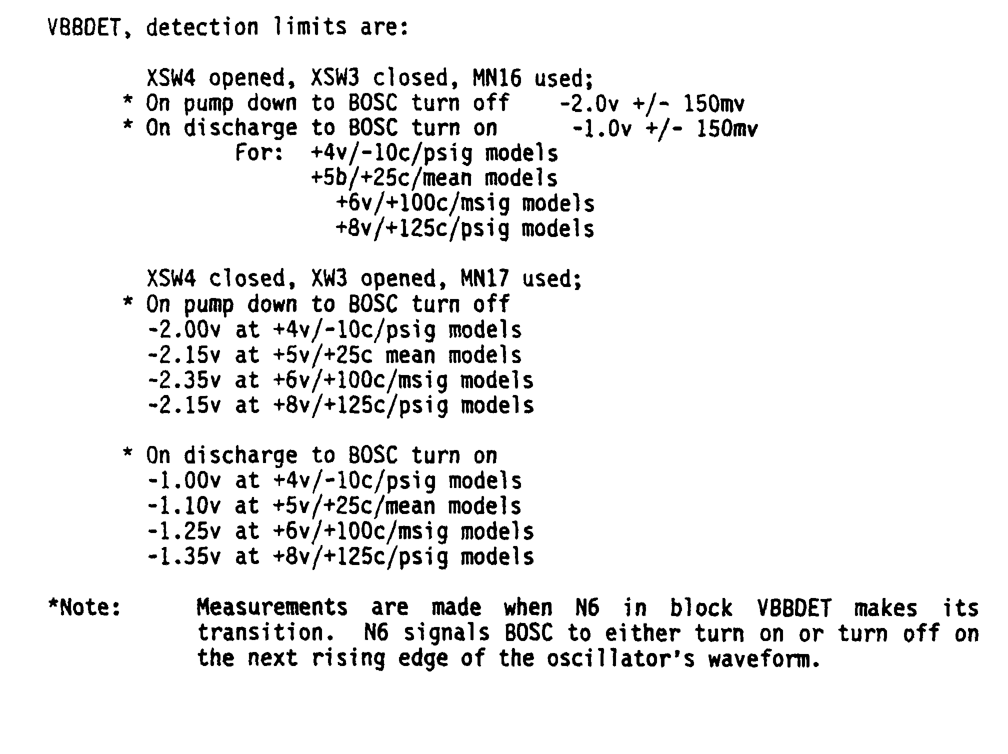

## Claims

1. An integrated circuit device formed in a semiconductor substrate, and having a circuit for providing a bias (VBB) to said substrate, said circuit comprising:
a first bias generator (LPOSC, VBBLPP) to provide said substrate bias in a standby mode of said integrated circuit device
a second bias generator (HPOSC, VBBHPP) to provide said substrate bias in an active mode of said integrated circuit device,
characterized by a third bias generator (BOSC, VBBPB) to provide said substrate bias in the active mode of said integrated circuit device and only when the substrate voltage level falls below a preset level.

2. An integrated circuit device as claimed in claim 1 wherein said circuit for providing a bias to said substrate is adapted to adjust to provide a bias to said substrate less than a level which adversely increases the threshold voltage Vt of the integrated circuit device transistors, yet sufficient to avoid junction leakage currents.

3. An integrated circuit device as claimed in any preceding claim and wherein said substrate is a p-type substrate, and said circuit provides a bias level of about -2 volts.

4. An integrated circuit device as claimed in any preceding claim and wherein said first bias generator is adapted to activate upon power up of said device and remains active until the power of the device is removed.

5. An integrated circuit device as claimed in any preceding claim and wherein at said first, second and third bias generators include respective first, second and third oscillators and pumps.

6. An integrated circuit device as claimed in any preceding claim and wherein said first bias generator includes an oscillator and pump adapted to run continuously whilst power is applied to said device.

7. An integrated circuit device as claimed in any preceding claim and wherein said bias generators include means to drive an oscillator to produce a square wave.

8. An integrated circuit device as claimed in claim 7 and wherein said means to drive said oscillator to produce a square wave comprises a plurality of stages each for successively steepening the wave gradient of said square wave.

9. An integrated circuit device as claimed in claim 7 or claim 8 and wherein said oscillator comprises a plurality of inverters to provide said square wave signals.

10. An integrated circuit device as claimed in any of the preceding claims 5-9 and including dynamic memory wherein said second oscillator and pump provide a substrate bias when RAS control input of said memory changes to active low.

11. An integrated circuit device as claimed in any of the preceding claims 5-10 and wherein said first oscillator is of relatively lower power and said second oscillator is of relatively higher power.

12. An integrated circuit device as claimed in any preceding claim and wherein said third bias generator has a higher driving capability than said second bias generator.

13. A method for controlling the voltage level of a substrate upon which an integrated circuit device is formed, comprising the steps of:
providing a low power oscillator and pump to provide a substrate bias in a standby mode of said device;
providing a high power oscillator and pump to provide said substrate bias in an active mode of said device; and
providing a booster oscillator and pump to provide said substrate bias when said device is in said active mode and only when the substrate voltage level is greater than a preset level.

14. The method for controlling substrate voltage according to claim 13 further comprising the step of adjusting the bias of said substrate to a bias level less than a level which adversely increases the threshold voltage Vt of the transistors of said integrated circuit device, and to a sufficiently high level to avoid junction leakage currents.

## Patentansprüche

1. Integrierte Schaltungsvorrichtung, die in einem Halbleitersubstrat gebildet ist und eine Schaltung besitzt, die für das Substrat eine Vorspannung (VBB) erzeugt, wobei die Schaltung enthält:
einen ersten Vorspannungsgenerator (LPOSC, VBBLPP), der die Substratvorspannung in einem Bereitschaftsmodus der integrierten Schaltungsvorrichtung erzeugt,
einen zweiten Vorspannungsgenerator (HPOSC, VBBHPP), der die Substratvorspannung in einem aktiven Modus der integrierten Schaltungsvorrichtung erzeugt,
gekennzeichnet durch
einen dritten Vorspannungsgenerator (BOSC, VBBPB), der die Substratvorspannung im aktiven Modus der integrierten Schaltungsvorrichtung und nur dann erzeugt, wenn der Substratspannungspegel unter einen im voraus festgelegten Pegel fällt.

2. Integrierte Schaltungsvorrichtung nach Anspruch 1, in der die Schaltung für die Erzeugung einer Vorspannung für das Substrat so eingestellt werden kann, daß sie eine Vorspannung für das Substrat erzeugt, die kleiner als ein Pegel ist, der die Schwellenspannung Vt der Transistoren der integrierten Schaltungsvorrichtung ungünstig erhöht, und die dennoch ausreicht, um Zonenübergangskriechströme zu vermeiden.

3. Integrierte Schaltungsvorrichtung nach irgendeinem vorgehenden Anspruch, in dem das Substrat ein p-Substrat ist und die Schaltung einen Vorspannungspegel von ungefähr -2 Volt erzeugt.

4. Integrierte Schaltungsvorrichtung nach irgendeinem vorgehenden Anspruch, in der der erste Vorspannungsgenerator so beschaffen ist, daß er beim Einschalten der Vorrichtung aktiviert wird und so lange aktiv bleibt, bis die Leistung der Vorrichtung abgeschaltet wird.

5. Integrierte Schaltungsvorrichtung nach irgendeinem vorgehenden Anspruch, in der der erste, der zweite und der dritte Vorspannungsgenerator einen ersten, einen zweiten bzw. dritten Oszillator und eine erste, eine zweite bzw. eine dritte Pumpe enthalten.

6. Integrierte Schaltungsvorrichtung nach irgendeinem vorgehenden Anspruch, in der der erste Vorspannungsgenerator einen Oszillator und eine Pumpe enthält, die so beschaffen sind, daß sie kontinuierlich laufen, wenn an die Vorrichtung Leistung angelegt wird.

7. Integrierte Schaltungsvorrichtung nach irgendeinem vorgehenden Anspruch, in der die Vorspannungsgeneratoren eine Oszillatortreibereinrichtung enthalten, um eine Rechteckwelle zu erzeugen.

8. Integrierte Schaltungsvorrichtung nach Anspruch 7, in der die Oszillatortreibereinrichtung für die Erzeugung einer Rechteckwelle mehrere Stufen enthält, wovon jede nacheinander den Wellengradienten der Rechteckwelle steiler macht.

9. Integrierte Schaltungsvorrichtung nach Anspruch 7 oder Anspruch 8, in der der Oszillator mehrere Inverter enthält, um die Rechteckwellensignale zu erzeugen.

10. Integrierte Schaltungsvorrichtung nach irgendeinem der vorangehenden Ansprüche 5-9, die eine dynamischen Speicher enthält und in der der zweite Oszillator und die zweite Pumpe eine Substratvorspannung erzeugen, wenn das RAS-Steuereingangssignal des Speichers zum aktiven niedrigen Pegel wechselt.

11. Integrierte Schaltungsvorrichtung nach irgendeinem der vorangehenden Ansprüche 5-10, in der der erste Oszillator eine verhältnismäßig niedrige Leistung besitzt und der zweite Oszillator eine verhältnismäßig hohe Leistung besitzt.

12. Integrierte Schaltungsvorrichtung nach irgendeinem vorangehenden Anspruch, in der der dritte Vorspannungsgenerator ein höheres Treibervermögen als der zweite Vorspannungsgenerator besitzt.

13. Verfahren zum Steuern des Spannungspegels eines Substrats, auf dem eine integrierte Schaltungsvorrichtung gebildet ist,
enthaltend die Schritte:
Erzeugen eines Oszillators und einer Pumpe mit niedriger Leistung, um in einem Bereitschaftsmodus der Vorrichtung eine Substratvorspannung zu erzeugen;
Erzeugen eines Oszillators und einer Pumpe mit hoher Leistung, um in einem aktiven Modus der Vorrichtung die Substratvorspannung zu erzeugen; und
Erzeugen eines Spannungserhöhungsoszillators und einer Spannungserhöhungspumpe, um die Substratvorspannung zu erzeugen, wenn sich die Vorrichtung im aktiven Modus befindet und nur dann, wenn der Substratspannungspegel größer als ein im voraus festgelegter Pegel ist.

14. Verfahren zum Steuern der Substratspannung nach Anspruch 13, ferner mit dem Schritt des Einstellens der Vorspannung des Substrats auf eine Vorspannung, die niedriger als ein Pegel ist, der die Schwellenspannung Vt der Transistoren der integrierten Schaltungsvorrichtung ungünstig erhöht, und die einen ausreichend hohen Pegel besitzt, um Zonenübergangskriechströme zu vermeiden.

## Revendications

1. Dispositif à circuit intégré formé dans un substrat à semiconducteur, et comportant un circuit pour fournir une polarisation (VBB) audit substrat, ledit circuit comprenant:
un premier générateur (LPOSC, VBBLPP) de polarisation pour fournir audit substrat une polarisation dans un mode d'attente dudit dispositif à circuit intégré,
un deuxième générateur (HPOSC, VBBHPP) de polarisation pour fournir audit substrat une polarisation dans un mode actif dudit dispositif à circuit intégré,
caractérisé par un troisième générateur (BOSC, VBBPB) de polarisation pour fournir audit substrat une polarisation dans le mode actif dudit dispositif à circuit intégré et uniquement lorsque le niveau de tension du substrat chute au-dessous d'un niveau pré-établi.

2. Dispositif à circuit intégré selon la revendication 1 dans lequel ledit circuit pour fournir une polarisation audit substrat est apte à effectuer un réglage pour fournir une polarisation audit substrat, inférieure à un niveau qui croît de manière inverse à la tension de seuil Vt des transistors du dispositif à circuit intégré, et cependant suffisante pour éviter les courants de fuite de jonction.

3. Dispositif à circuit intégré selon l'une quelconque des revendications précédentes et dans lequel ledit substrat est un substrat de type p, et ledit circuit fournit un niveau de polarisation d'environ - 2 volts.

4. Dispositif à circuit intégré selon l'une quelconque des revendications précédentes, et dans lequel ledit premier générateur de polarisation est apte à s'activer lors de l'alimentation dudit dispositif et reste actif jusqu'à ce que la puissance du dispositif soit supprimée.

5. Dispositif à circuit intégré selon l'une quelconque des revendications précédentes et dans lequel lesdits premier, deuxième et troisième générateurs de polarisation comportent respectivement des premiers, deuxièmes et troisièmes oscillateurs et pompes.

6. Dispositif à circuit intégré selon l'une quelconque des revendications précédentes, et dans lequel ledit premier générateur de polarisation comporte un oscillateur et une pompe aptes à fonctionner en continu tandis que de la puissance est appliquée audit dispositif.

7. Dispositif à circuit intégré selon l'une quelconque des revendications précédentes, et dans lequel lesdits générateurs de polarisation comportent un moyen pour commander un oscillateur afin de produire une onde carrée.

8. Dispositif à circuit intégré selon la revendication 7 et dans lequel ledit moyen pour commander ledit oscillateur afin de produire une onde carrée comprend une pluralité d'étages chacun, pour successivement échelonner le gradient d'onde de ladite onde carrée.

9. Dispositif à circuit intégré selon la revendication 7 ou la revendication 8 et dans lequel ledit oscillateur comprend une pluralité d'inverseurs pour obtenir lesdits signaux à onde carrée.

10. Dispositif à circuit intégré selon l'une quelconque des revendications précédentes 5-9 et comportant une mémoire dynamique dans laquelle lesdits deuxièmes oscillateur et pompe fournissent une polarisation de substrat lorsque l'entrée de commande RAS de ladite mémoire passe à un état actif bas.

11. Dispositif à circuit intégré selon l'une quelconque des revendications précédentes 5-10 et dans lequel ledit premier oscillateur est de puissance relativement faible et ledit deuxième oscillateur est de puissance relativement élevée.

12. Dispositif à circuit intégré selon l'une quelconque des revendications précédentes, et dans lequel ledit troisième générateur de polarisation a une capacité de commande supérieure à celle dudit deuxième générateur de polarisation.

13. Procédé de commande du niveau de tension d'un substrat sur lequel est formé un dispositif à circuit intégré, comprenant les étapes suivantes:
fourniture d'une pompe et d'un oscillateur basse puissance pour obtenir une polarisation de substrat dans un mode d'attente dudit dispositif;
fourniture d'une pompe et d'un oscillateur haute puissance pour obtenir ladite polarisation de substrat dans un mode actif dudit dispositif; et
fourniture d'une pompe et d'un oscillateur pré-amplificateur pour obtenir ladite polarisation de substrat lorsque ledit dispositif est dans ledit mode actif et uniquement lorsque le niveau de tension du substrat est supérieur à un niveau pré-établi.

14. Procédé de commande de la tension d'un substrat selon la revendication 13, comprenant en outre l'étape de réglage de la polarisation dudit substrat à un niveau de polarisation inférieur à un niveau qui croît de manière inverse à la tension de seuil Vt des transistors dudit dispositif à circuit intégré, et à un niveau suffisamment haut pour éviter les courants de fuite de jonction.
